Europäisches Patentamt

European Patent Office

Office européen des brevets

(11) Publication number: **0 382 557**
**A1**

## EUROPEAN PATENT APPLICATION

(21) Application number: **90301398.5**

(22) Date of filing: **09.02.90**

(51) Int. Cl.5: **H01B 3/00, C08K 9/06, H05K 1/03**

(30) Priority: **10.02.89 JP 31305/89**

(43) Date of publication of application:
**16.08.90 Bulletin 90/33**

(84) Designated Contracting States:
**AT BE CH DE DK ES FR GB GR IT LI LU NL SE**

(71) Applicant: **JUNKOSHA CO. LTD.**
**25-25, Miyasaka 2-chome**
**Setagaya-ku Tokyo 156(JP)**

(72) Inventor: **Sato, Yoshiaki,**
**Kawadera 350-7,**
**Hannoh-shi, Saitama(JP)**
Inventor: **Hoshiko, Takeshi**
**Higashicho 4-20,**
**Koganei-shi, Tokyo(JP)**

(74) Representative: **Foster, David Martyn et al**
**MATHISEN MACARA & CO. The Coach**
**House 6-8 Swakeleys Road**
**Ickenham Uxbridge UB10 8BZ(GB)**

(54) **Dielectric material.**

(57) A moisture resistant dielectric material which is formed by dispersing in an insulating high polymer material an inorganic filler material which has been surface treated with a fluorine-based silane coupling agent, especially $CF_3(CF_2)_7(CH_2)_2 Si(OCH_3)_3$

EP 0 382 557 A1

## DIELECTRIC MATERIAL

## FIELD OF THE INVENTION

The present invention pertains to a composite dielectric material which contains an inorganic filler material. An embodiment of the invention is a dielectric material which is improved in its moisture resistance, among other areas.

## BACKGROUND OF THE INVENTION

In the past, when high polymer materials have been used as dielectric materials, they have been compounded through the addition of various inorganic filler materials in an effort to improve their electrical properties. For instance, when attempting to raise the dielectric constant, a strong dielectric material such as barium titanate, calcium titanate or magnesium titanate should be added to a resin or rubber, as shown in Japanese Laid-Open Patent Application No. 63-228526. Conversely, when aiming to lower the dielectric constant, a filler material with a low dielectric constant, such as microscopic hollow glass spheres, is used.

When these fillers were added in a high concentration to a matrix material such as resin or rubber, a treatment was performed with a surface treating agent in order to improve the dispersion of the filler. Surfactants, metal soaps and the like have long been known as surface treating agents, but none of these is as yet completely satisfactory. Particularly from the standpoint of moisture resistance, use of these agents has led to little improvement, which has led to the problem of instability of electrical characteristics as well as to problems such as sharp increases in the dielectric dissipation factor.

The present invention aims to solve these problems inherent in conventional technology and provides a composite dielectric material with increased moisture resistance and other characteristics.

## SUMMARY OF THE INVENTION

It has now been discovered that a particular kind of silane coupling agent would overcome the above problems. Specifically, the present invention is a moisture resistant dielectric material which is formed by dispersing in an insulating high polymer material an inorganic filler material which has been surface treated with the fluorine-based silane coupling agent indicated by the following general formula:

$$Rf(CH_2)_2 Si(OR^1)_n R^2_{3-n}$$

where $Rf_2$ is a perfluoroalkyl group of one to ten carbon atoms, $R^1$ and $R^2$ are alkyl groups of one or two carbons and n is an integer one through three.

The invention also extends to an electrical circuit board formed from such a dielectric material.

## DESCRIPTION OF PREFERRED EMBODIMENTS

Examples of the insulating high polymer material which may be used in embodiments of the invention are a resin or a rubber, so long as it is a polymer with insulating properties. Examples include thermoplastic resins such as fluorinated resins, polyolefins, saturated polyesters, polyvinyl chloride, polyphenylene sulphide, polyphenylene oxide, polyether ether ketone, polyamides and polyurethanes, or heat setting resins such as polyimides, epoxy resins, unsaturated polyesters and polyamide-imides. The rubber can be silicone rubber or the like.

Inorganic fillers which can be used in the embodiments are selected depending on the intended use, and include strong dielectric materials such as barium titanate, calcium titanate, or titanium oxide; microscopic hollow spheres with a low dielectric constant, such as glass balloons or microballoons or glass; inorganic fibres such as glass fibre, carbon fibre, metal fibre, ceramic fibre, boron fibre, calcium titanate fibre or asbestos; powdered substances such as calcium carbonate, high dispersion silicon salts, alumina, talc, clay and mica, glass powder, quartz sand, metal powders, carbon black and barium sulphate, inorganic compounds in powder or sheet form such as silicon carbonate, alumina, boron nitrate and silicone nitrate, and having various shapes and qualities, such as whiskers and metal whiskers. Furthermore, these fillers can be used by combining two or more of the above.

In the embodiments, the fluorine-based silane coupling agent acts on the surface of the inorganic filler and modifies it through chemical bonding to render it hydrophobic. This coupling agent is a silane compound expressed by the above general formula. Examples of the perfluoroalkyl group indicated by the Rf in the formula include perfluoromethyl groups ($CF_3$-), perfluorobutyl groups ($C_4F_9$-) and perfluorooctyl groups ($C_8F_{17}$-), with $R^1$ and $R^2$ being methyl groups or ethyl groups. While the amount of these coupling agents added will vary depending on the material and properties such as particle diameters, surface area, and the like, they generally should be 0.1 to 5 wt % of the inorganic filler.

Under the embodiments, a fluorine-based silane coupling agent,

$Rf(CH_2)_2Si(OR^1)_nR^2_{3-n}$,

in which the critical surface tension has been drastically decreased, is used as the surface treating agent for the inorganic filler material through the introduction of a perfluoroalkyl group (Rf-). The alkoxy groups (-$OR^1$) in this coupling agent react and are bonded with the hydroxyl (-OH) and other groups in the water which is absorbed on the surface of the inorganic filler. As a result, the surface of the inorganic filler is covered with perfluoroalkyl groups which are bonded to the same silicon atoms. Because these perfluoroalkyl groups are hydrophobic groups with extremely low critical surface tensions, the surface of the inorganic filler becomes hydrophobic and is then subject to less influence by water. Moreover, when a high polymer material with low-energy interface characteristics, such as polytetrafluoroethylene, is used as the matrix material and since the affinity toward the matrix polymer material is heightened by the perfluoroalkyl groups present on the surface of the inorganic filler, particularly when the filler is used in a high concentration, very few gaps occur in the interface between the inorganic filler and the matrix polymer material, thus increasing the moisture resistance even more.

To prepare the compositions of the embodiments, the insulating high polymer is mixed with an inorganic filler that has been surface treated with the silane in the usual fashion. A liquid lubricating agent is usually employed. The resulting mixture can then be pressure-rolled to form a sheet.

The following is a description of practical examples embodying the invention, but the invention is not in any way limited by these examples.

Practical Example 1

67 parts by weight of barium titanate (N-5500, made by Fuji Titanium Engineering), which had been treated with 0.335 part by weight of perfluorooctyl trimethoxysilane (LP-8T, made by Shinetsu Chemical Engineering), was mixed with 33 parts by weight of a polytetrafluoroehtylene fine powder resin (Teflon 6J, made by Mitsui-DuPont Fluorochemical), after which solvent naphtha (IP-1620, made by Idemitsu Petrochemical) was added as a liquid lubricating agent, and the mixture left to sit for 12 hours at room temperature. These mixed components were then pressure rolled with a roller and moulded into a sheet form with a thickness of 0.15 mm, after which the sheet was calcined for three minutes at 370° C. to produce sheet-form dielectric material.

In order to examine the characteristics of this sheet-form dielectric material, both sides were overlaid with a 35 um thick copper foil with interposed 25 um thick tetrafluoroethylene-hexafluoropropylene copolymer resins, and this was then subjected to pressure-moulding in a heated press to produce a copper-clad laminated board. Measurements were then made for the surface resistance, volumetric resistivity, insulation resistance, dielectric constant, dielectric dissipation factor, and for the water absorption of this laminated board in a normal state and after a water absorption treatment, as is shown in the following table. Finally, these tests were performed in accordance with JIS Standard C6481, "Printed Circuit-Use Copper-Clad Laminated Boards."

| | | Practical Example 1 | Practical Example 2 | Comparative Example 1 | Comparative Example 2 |
|---|---|---|---|---|---|
| Surface Resistance ($\Omega$) | normal | $2.7 \times 10^{12}$ | $3.8 \times 10^{12}$ | $4.2 \times 10^{12}$ | $6.4 \times 10^{12}$ |
| | after WAT* | $2.7 \times 10^{12}$ | $3.5 \times 10^{12}$ | $1.0 \times 10^{11}$ | $3.9 \times 10^{9}$ |
| Volumetric Resistivity ($\Omega$ cm) | normal | $1.8 \times 10^{15}$ | $1.1 \times 10^{15}$ | $> 10^{17}$ | $> 10^{18}$ |
| | after WAT* | $9.3 \times 10^{14}$ | $1.6 \times 10^{15}$ | $1.9 \times 10^{12}$ | $8.2 \times 10^{10}$ |
| Insulation Resistance ($\Omega$) | normal | $7.6 \times 10^{14}$ | $8.7 \times 10^{13}$ | $1.2 \times 10^{11}$ | $1.3 \times 10^{11}$ |
| | after WAT* | $1.2 \times 10^{14}$ | $4.4 \times 10^{13}$ | $1.1 \times 10^{11}$ | $9.7 \times 10^{10}$ |
| Dielectric Constant ($1 \times 10^{6}$ Hz) | normal | 5.87 | 8.95 | 6.2 | 11.8 |
| | after WAT* | 5.99 | 9.11 | 10.3 | 22.0 |
| Dielectric Dissipation Factor ($1 \times 10^{6}$ Hz) | normal | 0.0004 | 0.0008 | 0.089 | 0.096 |
| | after WAT* | 0.0020 | 0.0031 | 1.05 | 1.04 |
| Water Absorption (%) | | 0.019 | 0.078 | 1.72 | 0.69 |

*: water absorption treatment

## Practical Example 2

86 parts by weight of barium titanate which had been treated with 0.43 part by weight of perfluorooctyl trimethoxysilane $[CF_3(CF_2)_7(CH_2)_2Si(OCH_3)_3]$ was mixed with 14 parts by weight of an polytetrafluoroethylene fine powder to produce a sheet-form dielectric material in the same manner as in Practical Example 1. Then a copper-clad laminated board was formed using this sheet-form dielectric material and similar tests were carried out. Those results are also shown in the table.

## Comparative Example 1

This example was conducted in the same manner as in Practical Example 1, with the exception that in place of the barium titanate treated with the fluorine-based silane coupling agent used in Practical Example 1, an untreated barium titanate was used. The results are shown in the table.

## Comparative Example 2

This example was conducted in the same manner as in Practical Example 2, with the exception that in place of the fluorine-based silane coupling agent used in Practical Example 2, the barium titanate was treated with octyl trimethoxysilane $[C_8H_{17}Si(OCH_3)_3]$, which is a silane coupling agent that does not contain any fluorine. The results are shown in the table.

As can be seen from the table, the effect of the fluorine-based coupling agents was demonstrated and it is clear that the dielectric material described has superior moisture resistance with small dielectric dissipation factor.

Finally, although not given as a practical example, similar tendencies were observed when other inorganic fillers, such as microscopic hollow glass spheres (microspheres), were blended into the polymer material instead of the barium titanate in order to obtain dielectric material with a low dielectric constant.

## Claims

4

1. A moisture resistant dielectric material comprising an insulating high polymer characterised by having dispersed therein an inorganic filler material which has been surface treated with a fluorine-based silane coupling agent of the general formula:

$$Rf(CH_2)_2Si(OR^1)_nR^2_{3-n}$$

where Rf is a perfluoroalkyl group of one to ten carbon atoms, $R^1$ and $R^2$ are alkyl groups of one to two carbon atoms, and n is an integer of one to three.

2. A dielectric material according to claim 1, characterised in that said insulating high polymer is an electrically insulating resin or rubber, selected from the class consisting of fluorinated resins, polyolefins, saturated polyesters, polyvinyl chloride, polyphenylene sulphide, polyphenylene oxide, polyether ether ketone, polyamides, polyurethanes, polyimides, epoxy resins, unsaturated polyesters, polyamide-imides, and silicone rubber.

3. A dielectric material according to claim 1, characterised in that said inorganic filler is selected from barium titanate, calcium titanate, titanium oxide, glass microspheres, glass balloons, glass, carbon, calcium titanate, metal, ceramic, boron, and asbestos fibres; powdered calcium carbonate, high-dispersion silicon salts, alumina, talc, clay, mica and glass; glass flakes, quartz sand, carbon black, metal powders, barium sulphate powder; sheet forms and powdered forms of silicon carbonate, alumina, baron nitrate, and silicon nitrate; metal whiskers and inorganic materials in whisker forms; and combinations of one or more of the above.

4. A dielectric material according to any preceding claim, characterised in that the amount of fluorine-based silane coupling agent ranges from about 0.1 to about 5% weight percent of the inorganic filler.

5. An electrical circuit board formed from a dielectric material according to claim 1.

6. An electrical circuit board formed from a dielectric material according to claim 2.

7. An electrical board formed from a dielectric material according to claim 3.

8. An electrical board formed from a dielectric material according to claim 4.

## DOCUMENTS CONSIDERED TO BE RELEVANT

| Category | Citation of document with indication, where appropriate, of relevant passages | Relevant to claim | CLASSIFICATION OF THE APPLICATION (Int Cl⁵) |
|---|---|---|---|
| X,Y | <u>US - A - 4 714 733</u> (ITOH et al.) * Column 3, line 3 - column 4, line 68; column 6, line 64 - column 7, line 3 * -- | 1-4, 5-8 | H 01 B 3/00 C 08 K 9/06 H 05 K 1/03 |
| Y | <u>US - A - 4 134 848</u> (ADICOFF et al.) * Abstract * | 5-8 | |
| A | * Abstract; column 3, lines 10-25 * -- | 2-4 | |
| A | <u>JP - A - 61-205 950</u> (TOSHIBA) * Page 2, right hand column, paragraph 2 * ---- | 1 | |
| | | | TECHNICAL FIELDS · SEARCHED (Int Cl⁵) H 01 B 3/00 C 08 K H 05 K 1/00 |

The present search report has been drawn up for all claims

| Place of search | Date of completion of the search | Examiner |
|---|---|---|
| VIENNA | 30-04-1990 | KUTZELNIGG |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82